(19) **Europäisches Patentamt**
**European Patent Office**
**Office européen des brevets**

(11) **EP 4 730 661 A1**

(12) **EUROPEAN PATENT APPLICATION**

(43) Date of publication:
**22.04.2026 Bulletin 2026/17**

(51) International Patent Classification (IPC):
*H03M 13/11* (2006.01)    *H03M 13/00* (2006.01)
*H04L 1/00* (2006.01)

(21) Application number: **25208929.7**

(22) Date of filing: **15.10.2025**

(52) Cooperative Patent Classification (CPC):
**H03M 13/116; H03M 13/1102; H03M 13/611;
H03M 13/6362; H03M 13/6516; H04L 1/0057;
H04L 1/0068**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **16.10.2024 US 202463708051 P
20.03.2025 US 202519085610**

(71) Applicant: **Avago Technologies International
Sales
Pte. Limited
Singapore 768923 (SG)**

(72) Inventors:
• **Pulikkoonattu, Rethnakaran**
  **Irvine, 92618 (US)**
• **Blanksby, Andrew**
  **Irvine, 92618 (US)**
• **Zheng, Jun**
  **Irvine, 92618 (US)**

(74) Representative: **Dilg, Haeusler, Schindelmann
Patentanwaltsgesellschaft mbH
Leonrodstraße 58
80636 München (DE)**

(54) **SYSTEMS AND METHODS FOR DETERMINING AND SIGNALING LOW-DENSITY
PARITY-CHECK (LDPC) ENCODING PARAMETERS**

(57)    In some implementations, a system may include a transmitter and one or more processors. The one or more processors may identify a bit indicating whether a codeword size is selected from a first set of codeword sizes or from a second set of codeword sizes. The one or more processors may select, based at least on the bit, a set of codeword sizes from one of the first set of codeword sizes or the second set of codeword sizes. The one or more processors may determine, from the selected set of codeword sizes, based at least on a number of available bits, the codeword size. The one or more processors may encode, via a low-density parity-check (LDPC) encoder, payload data using an LDPC code to generate encoded data including a codeword having the codeword size, and transmit, via the transmitter, a frame including the bit and the encoded data.

FIG. 3

EP 4 730 661 A1

Description

**Field of the Disclosure**

This disclosure generally relates to systems and methods for improving an encoding process and/or determining low-density parity-check (LDPC) encoding parameters (e.g., an LDPC codeword length, the number of LDPC codewords) and signaling information indicating the parameters.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits a codeword including payload data and parity bits, to the receiver communication system. The parity bits allow the receiver communication system to verify whether the received transmission is a valid codeword and to correct errors in the transmission if the received transmission is not a valid codeword. In one approach, the transmitter communication system may determine encoding parameters such as an LDPC codeword length, and encoding payload data using the encoding parameters.

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.

FIG. 2 is a schematic block diagram of a computing system, according to an embodiment.

FIG. 3 is a diagram depicting an example rate matching system, according to one or more embodiments.

FIG. 4A, FIG. 4B, and FIG. 4C are diagrams depicting example rate matching schemes including shortening, puncturing, and repeating, respectively, according to one or more embodiments.

FIG. 5 is a diagram depicting an example Physical Layer Protocol Data Unit (PPDU) format including a bit indicating a particular codeword length (e.g., 3888 bits), according to one or more embodiments.

FIG. 6A and FIG. 6B are diagrams depicting an example PPDU format including a bit indicating a particular codeword length (e.g., 3888 bits), according to one or more embodiments.

FIG. 7 is a flow diagram showing a process for encoding data using a bit indicating a particular codeword length (e.g., 3888 bits), in accordance with one or more embodiments.

FIG. 8 is a flow diagram showing a process for encoding data using a bit indicating a particular codeword length (e.g., 3888 bits), in accordance with one or more embodiments.

The details of various embodiments of the methods and systems are set forth in the accompanying drawings and the description below.

**Detailed Description**

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme. The term "error correction" refers to techniques used to detect and correct errors that occur during transmission of data over a network, or any techniques used to detect and correct errors or changes in digital data.

In one aspect, LDPC Physical Layer Protocol Data Unit (PPDU) encoding processes are defined in wireless communication standards (e.g., the IEEE 802.11n) to map an integer number of data bytes to an integer number of orthogonal frequency-division multiplexing (OFDM) symbols, and to an integer number of LDPC codewords. In error correction codes, e.g., LDPC codes, rate matching technique may be applied to adapt the code rate to match specific communication requirements. For example, the IEEE 802.11n standard defines, as rate matching techniques, shortening, puncturing, and/or repeating pattern for each codeword. An explicit payload length signaling defined in the standards (e.g., IEEE 802.11n) was replaced with an implicit scheme in the IEEE 802.11ac, for example, rounding payload up to the next pre-forward error correction (FEC) symbol boundary with pre-FEC padding. Such implicit scheme of 802.11ac was extended in the IEEE 802.11ax and the IEEE 802.11be with a-factor "short symbol padding." The a-factor values refer to packet extension (PE) durations for different pre-FEC padding boundaries. For example, an a-factor value of 1 indicates 4μs or ¼ long symbol, while an a-factor value of 4 indicates 16μs or 1 long symbol. A short symbol refers to a symbol created by reducing the number of subcarriers within a symbol (e.g., an OFDM symbol) which results in a shorter duration for the symbol. For multi-user (MU)-MIMO (multiple input multiple output) and orthogonal frequency-division multiple access (OFDMA), a two pass calculation can be used across all users to normalize the payload length to a common transmission length.

In one aspect, a PPDU encoding process may define a payload length $N_{pld}$ and the number of available bits $N_{avbits}$ as follows:

$$N_{pld} = length \times 8 + 16 \qquad \ldots\ldots\ldots\ldots\ldots \text{(Equation 1)},$$

$$N_{avbits} = N_{CBPS} \times (1 + U_{STBC}) \times ceil\left(\frac{N_{pld}}{N_{CBPS} \times R \times (1 + U_{STBC})}\right) \ldots\ldots\ldots\ldots\ldots \text{(Equation 2)},$$

where *length* is the number of octets in the payload; $N_{CBPS}$ is the number of coded bits per (OFDM) symbol; $U_{STBC}$ is 1 if space-time block coding (STBC) is used and is 0 otherwise; and R is a code rate. The available bits $N_{avbits}$ refers to the number of bits in a minimum number of modulation symbols in which the payload may fit.

In one aspect, Ultra High Reliability (UHR) is a new study group within the IEEE 802.11 working group. Its purpose is to investigate PHY (physical layer) and MAC (medium access control) technologies that can enhance the reliability of WLAN (wireless local area network) connectivity. The IEEE 802.11bn (UHR) standard is introducing a longer LDPC code (e.g., code with a block length of 3888 bits). According to amendments in IEEE 802.11, the exact size of the codeword can be determined based on the payload size, following a predefined PPDU encoding parameters specification. The latest amendment, IEEE 802.111be, specifies codeword sizes of 648, 1296, and 1944. To accommodate LDPC codes with a larger codeword length (e.g., block length of 3888), the predefined PPDU encoding parameters specification may need to be updated.

To solve these problems, according to certain aspects, embodiments in the present disclosure relate to a technique to provide/support/utilize LDPC signaling of a codeword length of 2x1944 bits and PPDU encoding parameters. The codeword refers to an output of an encoder into which original data are encoded, a sequence of symbols that represents encoded data, or encoded data including both the original information and additional redundant bits added for error detection and correction. To provide flexibility, in some implementations, a signaling bit can be introduced to indicate the use of 3888-blocklength LDPC codes in a transmitter. The transmitter in wireless or wireless networks refers to a device or component (software, firmware, hardware, processors, circuitry) that can send data by transmitting the data through an antenna, or a device or component (software, firmware, hardware, processors, circuitry) that can send data over a physical transmission medium (e.g., cables, optics, radio waves, microwaves, infrared, light transmissions). In some implementations, this signaling information can be conveyed to the receiver to ensure accurate decoding of transmitted packets. In line with the existing naming convention of the STBC signaling bit, $m_{STBC}$, a new signaling bit field, $m_{2xLDPC}$, can be used such that $m_{2xLDPC} = 1$ indicates the inclusion of 3888-blocklength LDPC codes in the PPDU encoding process. In some implementations, the name of the signaling bit field is not limited to $m_{2xLDPC}$. The signaling bit can be referred to as indicator bit, longer_ldpc, ldpc_2x, 2xLDPC, or 2x1944, for example. In some implementations, the PPDU encoding process can follow the steps outlined in the tables below (e.g., Table 1, Table 2, Table 3, or Table 4).

In some implementations, a PPDU for UHR can include a signaling bit $m_{2xLDPC}$ as part of the UHR-SIG field. For example, a UHR multi-user (MU) PPDU can be used for transmission to one or more users and is not a response to a triggering frame. The term "frame" refers to data for organizing and managing data transmission over a communication network, a data unit containing all the information required for communication (e.g., source address, destination address, payload, control fields, etc.), or any data packet that includes all necessary information for communication between devices. In some implementations, the UHR-SIG field including a signaling bit $m_{2xLDPC}$ can be present in the UHR MU PPDU.

In some implementations, a UHR trigger-based (TB) PPDU can be used for a transmission that is a response to a triggering frame from an AP. In some implementations, in the UHR TB PPDU, the UHR-SIG field is not present and the duration of the UHR-STF (short training field) field is twice the duration of the UHR-STF field in the UHR MU PPDU. In some implementations, a UHR variant User Info field can be defined for all Trigger frame variants except the Neighbor Discovery Protocol (NDP) Feedback Report Poll (NFRP) Trigger frame and the MU-RTS (Request to Send) TXS (Transmit Opportunity Sharing) Trigger frame. In some implementations, the User Info field in a TB PPDU may have a signaling bit $m_{2xLDPC}$. In some implementations, the signaling bit $m_{2xLDPC}$ may be bit 26 of the User Info field in the TB PPDU.

In some implementations, in Table 1 below (as option 1), the symbol $m_{2xLDPC}$ represents the signaling bit $m_{2xLDPC}$, where $m_{2xLDPC} = 1$ can indicate a LDPC codeword size (or length) of 3888 bits, which is 2x(the codeword length of the base 1944 bits LDPC code). In some implementations, $m_{2xLDPC} = 1$ can indicate other LDPC codeword lengths, for example, 2x(the codeword length of a base LDPC code), etc. In some implementations, the signaling bit $m_{2xLDPC} = 0$ can indicate that the codeword size shall follow the pre-UHR LDPC scheme, e.g., 648, 1296, or 1944 bits. In some implementations, a specific codeword size (or length) $L_{LDPC}$ can be selected or determined based on the PPDU payload size (or length) $N_{pld}$, the number of available bits $N_{avbits}$, $m_{2xLDPC}$, or a code rate $R$, following the mapping outlined in Table 1. In some implementations, a specific number of codewords $N_{CW}$ can be determined or selected based on the PPDU payload size (or length) $N_{pld}$, the number of available bits $N_{avbits}$, $m_{2xLDPC}$, or a code rate $R$, following the mapping outlined in Table 1.

Table 1. Calculation of the LDPC codeword size (length) $L_{LDPC}$ and the number of codewords $N_{CW}$ (Option 1)

| Range of $N_{avbits}$ (bits) | Number of LDPC codewords ($N_{CW}$) | LDPC codeword length $L_{LDPC}$ (bits) | Possible values of $m_{2xLDPC}$ |
|---|---|---|---|
| $N_{avbits} \leq 648$ | 1 | 1296, if $N_{avbits} \geq N_{pld} + 912 \times (1\text{-}R)$ <br> 648, otherwise | 0 |
| $648 < N_{avbits} \leq 1296$ | 1 | 1944, if $N_{avbits} \geq N_{pld} + 1464 \times (1\text{-}R)$ <br> 1296, otherwise | 0 |
| $1296 < N_{avbits} \leq 1944$ | 1 | 1944 | 0 |
| $1944 < N_{avbits} \leq 2592$ | 2 | 1944, if $N_{avbits} \geq N_{pld} + 2916 \times (1\text{-}R)$ <br> 1296, otherwise | 0 |
| $2592 < N_{avbits} \leq 3888$ | $\left\lceil \dfrac{N_{pld}}{1944 \cdot R} \right\rceil$ | 1944 | 0 |
| $N_{avbits} > 3888$ | $\left\lceil \dfrac{N_{pld}}{(1 + m_{2xLDPC}) \cdot 1944 \cdot R} \right\rceil$ | $(1 + m_{2xLDPC})\,1944$ | 0,1 |

In some implementations, in Table 2 below (as option 1a), the symbol $m_{2xLDPC}$ represents the signaling bit $m_{2xLDPC}$, where $m_{2xLDPC} = 1$ indicates an LDPC codeword size (or length) of 3888 bits, which is 2x(the codeword length of the base 1944 bits LDPC code). In some implementations, $m_{2xLDPC} = 1$ can indicate other LDPC codeword lengths, for example, 2x(the codeword length of a base LDPC code), etc. In some implementations, the signaling bit $m_{2xLDPC} = 0$ can indicate that the codeword size follows the pre-UHR LDPC scheme, e.g., 648, 1296, or 1944 bits. In some implementations, a specific codeword size (or length) $L_{LDPC}$ can be selected or determined based on the PPDU payload size (or length) $N_{pld}$, the number of available bits $N_{avbits}$, $m_{2xLDPC}$, or a code rate $R$, following the mapping outlined in Table 2. In some implementations, a specific number of codewords $N_{CW}$ can be determined or selected based on the PPDU payload size (or length) $N_{pld}$, the number of available bits $N_{avbits}$, or $m_{2xLDPC}$, following the mapping outlined in Table 2.

Table 2. Table 1. Calculation of the LDPC codeword size (length) $L_{LDPC}$ and the number of codewords $N_{CW}$ (Option 1a)

| Range of $N_{avbits}$ (bits) | Number of LDPC codewords ($N_{CW}$) | LDPC codeword length $L_{LDPC}$ (bits) | Possible values of $m_{2xLDPC}$ |
|---|---|---|---|
| $N_{avbits} \leq 648$ | 1 | 1296, if $N_{avbits} \geq N_{pld} + 912 \times (1-R)$ 648, otherwise | 0 |
| $648 < N_{avbits} \leq 1296$ | 1 | 1944, if $N_{avbits} \geq N_{pld} + 1464 \times (1-R)$ 1296, otherwise | 0 |
| $1296 < N_{avbits} \leq 1944$ | 1 | 1944 | 0 |
| $1944 < N_{avbits} \leq 2592$ | 2 | 1944, if $N_{avbits} \geq N_{pld} + 2916 \times (1-R)$ 1296, otherwise | 0 |
| $2592 < N_{avbits} \leq 3888$ | 2 | 1944 | 0 |
| $N_{avbits} > 3888$ | $\left\lceil \dfrac{N_{pld}}{(1 + m_{2xLDPC}) \cdot 1944} \right\rceil$ | $(1 + m_{2xLDPC})$ 1944 | 0,1 |

In some implementations, in Table 3 below (as option 2), the symbol $m_{2xLDPC}$ represents the signaling bit $m_{2xLDPC}$, where $m_{2xLDPC} = 1$ indicates that the LDPC codeword size is one from the set of 648, 1296, 1944, or 3888 bits. In some implementations, the signaling bit $m_{2xLDPC} = 0$ can indicate that the codeword size follows the pre-UHR LDPC scheme, e.g., 648, 1296, or 1944 bits. In some implementations, the signaling bit $m_{2xLDPC} = 0$ indicates that the LDPC codeword size is one from the set of 648, 1296, or 1944. In some implementations, a specific codeword size (or length) $L_{LDPC}$ can be selected or determined based on the PPDU payload size (or length) $N_{pld}$, the number of available bits $N_{avbits}$, $m_{2xLDPC}$, or a code rate $R$, following the mapping outlined in Table 3. In some implementations, a specific number of codewords $N_{CW}$ can be determined or selected based on the PPDU payload size (or length) $N_{pld}$, the number of available bits $N_{avbits}$, $m_{2xLDPC}$, or a code rate $R$, following the mapping outlined in Table 3.

Table 3. Calculation of the LDPC codeword size (length) $L_{LDPC}$ and the number of codewords $N_{CW}$ (Option 2)

| Range of $N_{avbits}$ (bits) | Number of LDPC codewords ($N_{CW}$) | LDPC codeword length $L_{LDPC}$ (bits) | Possible values of $m_{2xLDPC}$ |
|---|---|---|---|
| $N_{avbits} \leq 648$ | 1 | 1296, if $N_{avbits} \geq N_{pld} + 912 \times (1-R)$ 648, otherwise | 0 |
| $648 < N_{avbits} \leq 1296$ | 1 | 1944, if $N_{avbits} \geq N_{pld} + 1464 \times (1-R)$ 1296, otherwise | 0 |
| $1296 < N_{avbits} \leq 1944$ | 1 | 1944 | 0 |
| $1944 < N_{avbits} \leq 2592$ | 2 | 1944, if $N_{avbits} \geq N_{pld} + 2916 \times (1-R)$ 1296, otherwise | 0 |
| $2592 < N_{avbits} \leq 3888$ | $\left\lceil \dfrac{N_{pld}}{1944 \cdot R} \right\rceil$ | 1944 | 0 |
| $N_{avbits} > 3888$ | $\left\lceil \dfrac{N_{pld}}{(1 + m_{2xLDPC}) \cdot 1944 \cdot R} \right\rceil$ | $(1 + m_{2xLDPC})$ 1944 | 0,1 |

In some implementations, in Table 4 below (as option 2a), the symbol $m_{2xLDPC}$ represents the signaling bit

$m_{2xLDPC}$, where $m_{2xLDPC} = 1$ indicates that the LDPC codeword size is one from the set of 648, 1296, 1944, or 3888 bits. In some implementations, the signaling bit $m_{2xLDPC} = 0$ can indicate that the codeword size follows the pre-UHR LDPC scheme, e.g., 648, 1296, or 1944 bits. In some implementations, the signaling bit $m_{2xLDPC} = 0$ indicates that the LDPC codeword size is one from the set of 648, 1296, or 1944. In some implementations, a specific codeword size (or length) $L_{LDPC}$ can be selected or determined based on the PPDU payload size (or length) $N_{pld}$, the number of available bits $N_{avbits}$, $m_{2xLDPC}$, or a code rate $R$, following the mapping outlined in Table 2. In some implementations, a specific number of codewords $N_{CW}$ can be determined or selected based on the PPDU payload size (or length) $N_{pld}$, the number of available bits $N_{avbits}$, or $m_{2xLDPC}$, following the mapping outlined in Table 4.

Table 4. Calculation of the LDPC codeword size (length) $L_{LDPC}$ and the number of codewords $N_{CW}$ (Option 2a)

| Range of $N_{avbits}$ (bits) | Number of LDPC codewords ($N_{CW}$) | LDPC codeword length $L_{LDPC}$ (bits) | Possible values of $m_{2xLDPC}$ |
|---|---|---|---|
| $N_{avbits} \leq 648$ | 1 | 1296, if $N_{avbits} \geq N_{pld} + 912 \times (1-R)$ 648, otherwise | 0 |
| $648 < N_{avbits} \leq 1296$ | 1 | 1944, if $N_{avbits} \geq N_{pld} + 1464 \times (1-R)$ 1296, otherwise | 0 |
| $1296 < N_{avbits} \leq 1944$ | 1 | 1944 | 0 |
| $1944 < N_{avbits} \leq 2592$ | 2 | 1944, if $N_{avbits} \geq N_{pld} + 2916 \times (1-R)$ 1296, otherwise | 0 |
| $2592 < N_{avbits} \leq 3888$ | 2 | 1944 | 0 |
| $N_{avbits} > 3888$ | $\left\lceil \dfrac{N_{pld}}{(1 + m_{2xLDPC}) \cdot 1944} \right\rceil$ | $(1 + m_{2xLDPC})$ 1944 | 0,1 |

In some implementations, a system (e.g., a communication system for transmitting or receiving data) can select the 3888-bit codeword using an indicator bit, $m_{2xLDPC}$, to signal that a PPDU is encoded with a 3888-bit LDPC code, as outlined in Option 1 (Table 1) and Option 2 (Table 2). In some implementations, the system can use the indicator bit, $m_{2xLDPC}$, to signal that the codeword size of 3888 bit is a possible codeword size, with other codeword sizes such as 648, 1296, or 1944 also being possible, as outlined in Option 2 (Table 3) and Option 2a (Table 4).

In some implementations, the system can decipher or determine the exact codeword length based on tables (e.g., Table 1, Table 2, Table 3, or Table 4). For example, the system (e.g., a transmitter) can set the indicator bit $m_{2xLDPC}$ after deciding or determining whether to encode a PPDU with a 3888-bit codeword LDPC or not. In some implementations, the system can decide whether to include the 3888-bit codeword size in a set of possible codeword sizes. In some implementations, the system can make the decision based at least on (1) a payload length, (2) a modulation size, (3) a bandwidth, (4) FFT (Fast Fourier Transform) size, (5) a resource unit (RU), (6) a data rate, (7) latency requirements, (8) a percentage (or number) of punctured bits, (9) a ratio of punctured bits to shortened bits ratio, (10) the number of spatial streams (NSS), (11) modulation and coding scheme (MCS), or (12) a metric chosen as a function of (1)-(11). The data rate refers to bits per second (bps), kilobits per second (Kbps), megabits per second (Mbps), gigabits per second (Gbps) or any value representing the speed at which data is transmitted from one device to another. The Modulation and Coding Scheme (MCS) refers to a combination of modulation, coding rate and other parameters, or any metric that determines the data rate and robustness of a wireless link. The modulation size refers to a modulation order (e.g., modulation order in QAM (quadrature amplitude modulation)), or the number of distinct symbols that can be used to represent data in a modulation scheme. The bandwidth refers to a data bandwidth, a network bandwidth, a digital bandwidth, a maximum rate of data transfer across a given path, or a maximum rate at which data can be transmitted over a network connection in a given amount of time. The resource unit (RU) refers to a bandwidth unit used in Orthogonal Frequency-Division Multiple Access (OFDMA), or a group of subcarriers or tones within a given frequency bandwidth.

In some implementations, the latency requirements may be a metric based on latency requirements of applications. For example, data transmission for some delay-sensitive applications may be potentially restricted from using the 3888-bit codeword size. In some implementations, the percentage of punctured bits (or the fraction of punctured bits) may be a percentage of bits (e.g., parity bits) that may go through puncturing (deletion) during a LDPC rate matching process. In some implementations, the percentage of punctured bits may vary depending on at least one of a payload length, a code rate, and/or a modulation and coding scheme (MCS). The higher the percentage of punctured bits is, the more severe the loss in performance may be. In some implementations, the system can (1) place, determine, set, or use a puncturing threshold (e.g., a threshold for a number of punctured bits or a threshold for a percentage of threshold) for a given MCS, a bandwidth, and an RU, (2) compare the percentage (or number) of punctured bits with the puncturing threshold, and (3) decide, based on a comparison result, whether to include the 3888-bit codeword size in a set of possible codeword sizes. For example, in response to determining that the percentage of punctured bits is greater than the puncturing threshold, the system can decide not to include the 3888-bit codeword size in the set of possible codeword sizes. In some implementations, the puncturing threshold is a fixed value.

In some implementations, the system can dynamically change the puncturing threshold. In some implementations, in deciding whether to include a larger codeword size (e.g., the 3888-bit codeword size) in a set of possible codeword sizes, the system can take into consideration the PPDU encoding process, which includes shortening, puncturing, and repeating of codeword bits. Puncturing of parity bits results in coding performance degradation. In some implementations, the system can estimate, based on the number (or percentage) of punctured parity bits, the relative coding performance of 1944-bit and 3888-bit codes for a given scenario. In some implementations, the system can find, select, or identify a threshold of parity puncturing for the 3888-bit code (with a certain code rate), for which there is no coding performance degradation compared to the 1944-bit code (with the same rate). In some implementations, in response to determining that the number (or percentage) of punctured parity bits is smaller than the identified threshold, the system can use the 3888-bit code for such scenarios. In some implementations, in response to determining that the number (or percentage) of punctured parity bits exceeds the identified threshold, the system can use a second metric to decide which codeword length to use.

Embodiments in the present disclosure have at least the following advantages and benefits.

First, embodiments in the present disclosure can provide useful techniques for utilizing LDPC signaling of a codeword length of 2x1944 bits and PPDU encoding parameters. In some implementations, the system (e.g., a transmitter) can use a signaling bit to flexibly indicate the use of 3888-blocklength LDPC codes. For example, the signaling bit can indicate the use of 3888-blocklength LDPC codes or the inclusion of 3888-blocklength LDPC codes in a set of possible codeword sizes. In some implementations, this signaling information can be conveyed to the receiver to ensure accurate decoding of transmitted packets.

Second, embodiments in the present disclosure can provide useful techniques for finding, selecting, or identifying a threshold of parity puncturing for the 3888-bit LDPC code (with a certain code rate), for which there is no coding performance degradation compared to the 1944-bit LDPC code (with the same rate). In this manner, the system can use the 3888-bit LDPC code when there is no coding performance degradation compared to the 1944-bit LDPC code.

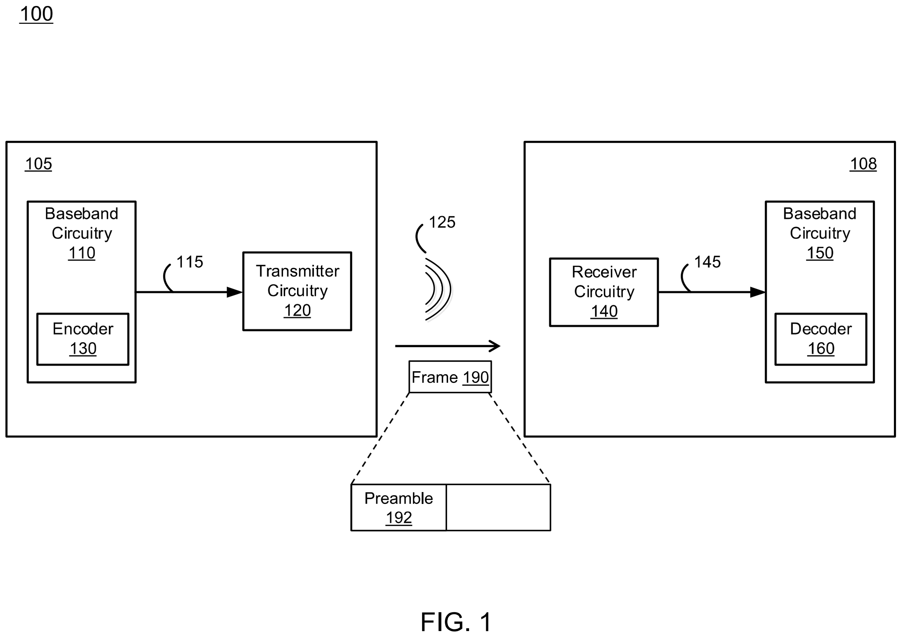

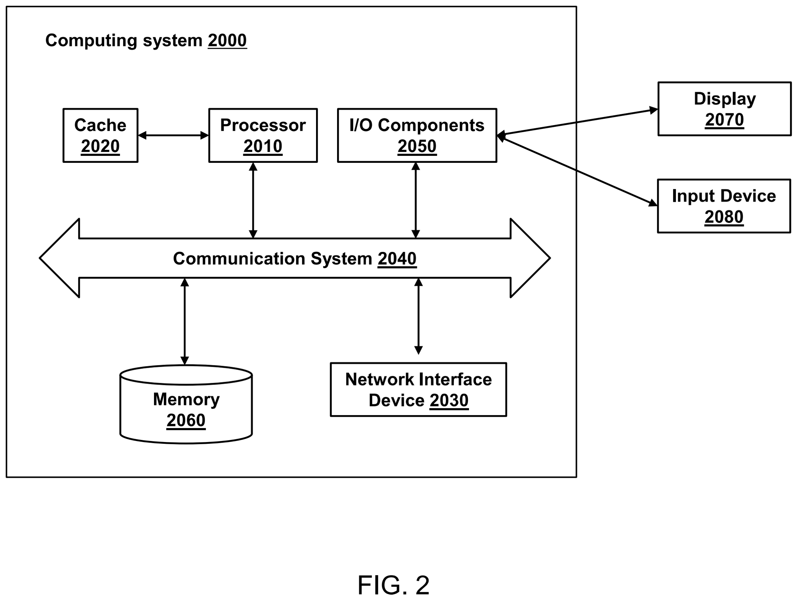

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some embodiments, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some embodiments, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data, and generates or outputs parity bits. In one aspect, the baseband circuitry 110 (or encoder 130) obtains a generator matrix or a parity check matrix, or uses a previously produced generator matrix or a previously produced parity check matrix, and encodes the information data by applying the information data to the generator matrix or the parity check matrix to obtain a codeword. In some embodiments, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix, and appends the parity bits to the information bits to form a codeword. The baseband circuitry 110 generates the baseband data 115 including the codeword for the communication system 108, and provides the baseband data 115 to the transmitter circuitry 120.

The transmitter circuitry 120 of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at an RF frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though an antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some embodiments, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2, and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multicore processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

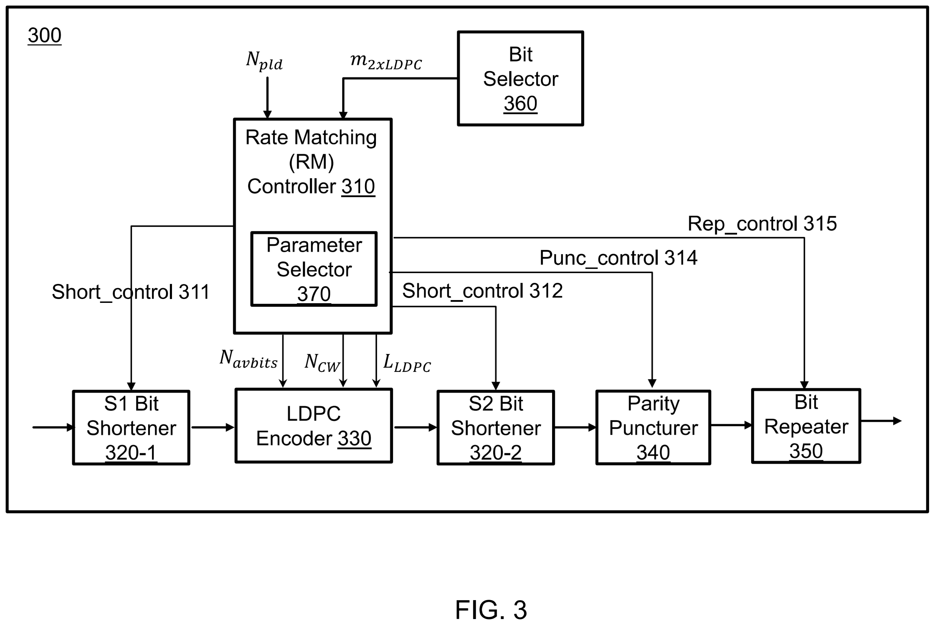

FIG. 3 is a diagram depicting an example rate matching system 300, according to one or more embodiments. The rate matching system 300 may include a rate matching (RM) controller 310, an LDPC encoder 330, a bit shortener including a stage-1 (S1) bit shortener 320-1 and a stage-2 (S2) bit shortener 320-2, a parity puncturer 340, and/or a bit repeater 350. The term "encoder" refers to a device or component (e.g., software, firmware, hardware, circuitry or a combination thereof) for error correction using error correction codes (ECC) including LDPC codes, or any device or component (e.g., software, firmware, hardware, circuitry or a combination thereof) that transforms original data into a coded format (e.g., codeword including both original data and additional data for error correction). The S1 bit shortener 320-1 may perform bit shortening by adding shortened bits (e.g., zeros) prior to encoding, and the S2 bit shortener 320-2 may perform bit shortening removal by removing the shortened bits (e.g., zeros) after encoding. The rate matching system 300 may be included in an encoder (e.g., encoder 130) or baseband circuitry (e.g., baseband circuitry 110). The rate matching system 300 may be implemented as one or more processors, ASIC, FPGA, or any combination of them. The RM controller 310 may receive/obtain/identify/calculate at least one of $N_{pld}$, $m_{2xLDPC}$ and calculate/compute/obtain at least one of the number of available bits $N_{avbits}$ (e.g., using Equation 2), the number of codewords $N_{CW}$, or LDPC codeword length $L_{LDPC}$ (e.g., using Table 1, Table 2, Table 3 or Table 4 depending on different implementations). The RM controller then may provide the calculated $N_{avbits}$, $N_{CW}$, or $L_{LDPC}$ (as encoder parameters) to the LDPC encoder 330 so that the LDPC encoder 330 can encode data according to the encoder parameters.

In some implementations, the rate matching system 300 may include a bit selector 360 which may be implemented as one or more processors, ASIC, FPGA, or any combination of them. The bit selector 360 can set (and output) the indicator bit $m_{2xLDPC}$ after deciding or determining whether to encode a PPDU with a 3888-bit codeword LDPC or not. For example, in response to determining to encode a PPDU with a 3888-bit codeword LDPC, the bit selector 360 can set the indicator bit $m_{2xLDPC}$ to 1; and otherwise, the bit selector 360 can set the indicator bit $m_{2xLDPC}$ to 0. The bit selector 360 can decide whether to include the 3888-bit codeword size in a set of possible codeword sizes or not. For example, in response to determining to include the 3888-bit codeword size in a set of possible codeword sizes (for encoding), the bit selector 360 can set the indicator bit $m_{2xLDPC}$ to 1; and otherwise, the bit selector 360 can set the indicator bit $m_{2xLDPC}$ to 0. The bit selector 360 can make the decision based at least on (1) a payload length, (2) a modulation size, (3) a bandwidth, (4) FFT size, (5) a resource unit (RU), (6) a data rate, (7) latency requirements, (8) a percentage (or number) of punctured bits, (9) a ratio of punctured bits to shortened bits ratio, (10) the number of spatial streams (NSS), (11) modulation and coding scheme (MCS), or (12) a metric chosen as a function of (1)-(11).

In some implementations, the bit selector 360 can (1) place, determine, set, or use a puncturing threshold (e.g., a threshold for a number of punctured bits or a threshold for a percentage of punctured bits) for a given MCS, a bandwidth, and an RU, (2) compare the percentage (or number) of punctured bits with the puncturing threshold, and (3) decide, based on a comparison result, whether to include the 3888-bit codeword size in a set of possible codeword sizes. For example, in response to determining that the percentage of punctured bits is greater than the puncturing threshold, the bit selector 360 can decide not to include the 3888-bit codeword size in the set of possible codeword sizes. In some implementations, the puncturing threshold is a fixed value.

In some implementations, the bit selector 360 can dynamically change the puncturing threshold. In some implementations, in deciding whether to include a larger codeword size (e.g., the 3888-bit codeword size) in a set of possible codeword sizes, the bit selector 360 can take into consideration the PPDU encoding process, which includes shortening, puncturing, and repeating of codeword bits. Puncturing of parity bits results in coding performance degradation. In some implementations, the bit selector 360 can estimate, based on the number (or percentage) of punctured parity bits, the relative coding performance of 1944-bit and 3888-bit codes for a given scenario. In some implementations, the bit selector 360 can find, select, or identify a threshold of parity puncturing for the 3888-bit code (with a certain code rate), for which there is no coding performance degradation compared to the 1944-bit code (with the same rate). In some implementations, in response to determining that the number (or percentage) of punctured parity bits is smaller than the identified threshold, the bit selector 360 can use the 3888-bit code for such scenarios. In some implementations, in response to determining that the number (or percentage) of punctured parity bits exceeds the identified threshold, the bit selector 360 can use a second metric to decide which codeword length to use.

In some implementations, the RM controller 310 may include a parameter selector 370. The parameter selector 370 can select or determine a specific codeword size (or length) $L_{LDPC}$ based on the PPDU payload size (or length) $N_{pld}$, the number of available bits $N_{avbits}$, $m_{2xLDPC}$, or a code rate $R$, following the mapping outlined in Table 1, Table 2, Table 3 or Table 4 depending on different implementations. The parameter selector 370 can determine or select a specific number of codewords $N_{CW}$ based on the PPDU payload size (or length) $N_{pld}$, the number of available bits $N_{avbits}$, $m_{2xLDPC}$, or a code rate $R$, following the mapping outlined in Table 1, Table 2, Table 3 or Table 4 depending on different implementations.

Referring to FIG. 3, the RM controller 310 can control, based on $N_{avbits}$, $N_{CW}$, and/or $L_{LDPC}$ as calculated above, at least one of the S1 bit shortener 320-1, the S2 bit shortener 320-2, the parity puncturer 340, or the bit repeater 350. For example, the RM controller 310 can control the S1 bit shortener 320-1 and/or the S2 bit shortener 320-2 using one or more control signals (e.g., short_control 311, short_control 312) based on a value of the number of shortened bits $N_{shrt}$ calculated using Equation 3 below.

$$N_{shrt} = max\left(0, (N_{CW} \times L_{LDPC} \times R) - N_{pld}\right) \dots\dots\dots\dots \text{(Equation 3)},$$

where shortened bits may be evenly distributed over all codewords with the first $rem(N_{shrt}, N_{CW})$ codewords shortened by 1 more bit. Here, r = rem(a, b) returns the remainder after division of a by b, where a is the dividend and b is the divisor.

The RM controller 310 can control the parity puncturer 340 using a control signal (e.g., punc_control 314) based on a value of the number of punctured bits $N_{punc}$ calculated using Equation 4 below.

$$N_{punc} = max(0, (N_{CW} \times L_{LDPC}) - N_{avbits} - N_{shrt}) \dots\dots\dots\dots \text{(Equation 4)}.$$

The RM controller 310 can control the bit repeater 350 using a control signal (e.g., rep_control 315) based on a value of the number of repeated bits $N_{rep}$ calculated using Equation 5.

$$N_{rep} = max\left(0, N_{avbits} - (N_{CW} \times L_{LDPC}) - N_{pld}\right) \dots\dots\dots\dots \text{(Equation 5)},$$

where repeated bits are evenly distributed over all codewords with the first $rem(N_{rep}, N_{CW})$ codewords having 1 repeated bit more.

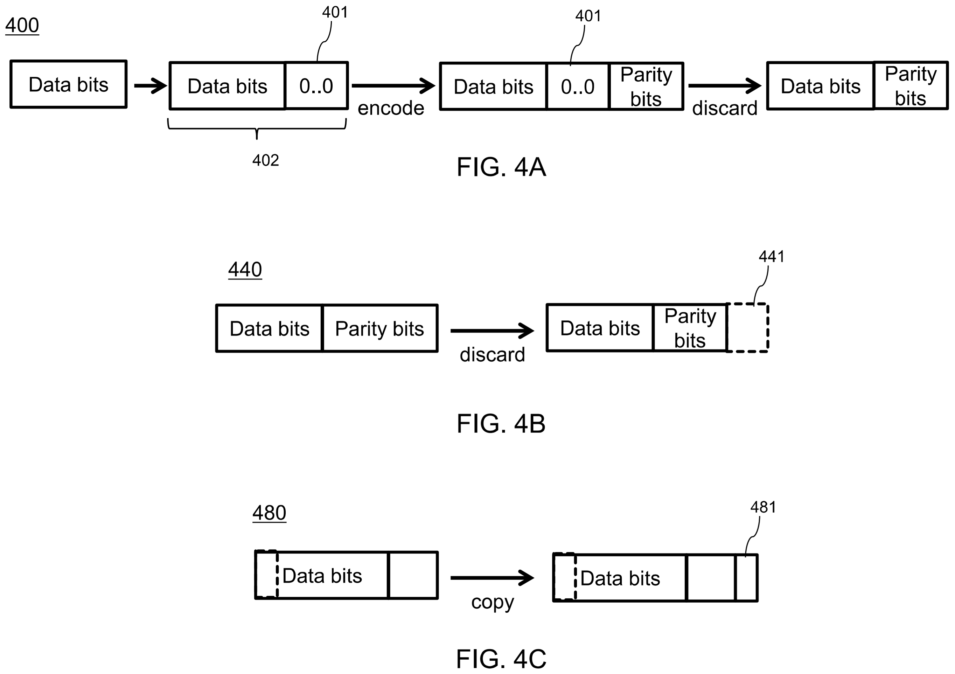

FIG. 4A, FIG. 4B, and FIG. 4C are diagrams 400, 440, 480 depicting example rate matching schemes including shortening, puncturing, and repeating, respectively, according to one or more embodiments. Referring to FIG. 4A, the bit shortener (e.g., S1 bit shortener 320-1 and S2 bit shortener 320-2) may zero pad data bits (e.g., zero padded bits or "shortened bits" 401) to match the number of systematic bits per codeword (e.g., systematic bits 402) before encoding, and discard the shortened bits 401 after encoding. In this manner, the bit shortener can reduce the effective code rate and improve coding gain.

Referring to FIG. 4B, the parity puncturer (e.g., parity puncturer 340) may discard some parity bits (e.g., "punctured bits" 441) after encoding. In this manner, the parity puncturer 340 can increases the effective code rate and degrade a coding gain. Referring to FIG. 4C, the bit repeater (e.g., bit repeater 350) may copy some bits (e.g., "repeated bits" 481) from the start of the codeword. In this manner, the bit repeater 350 can improve coding gain.

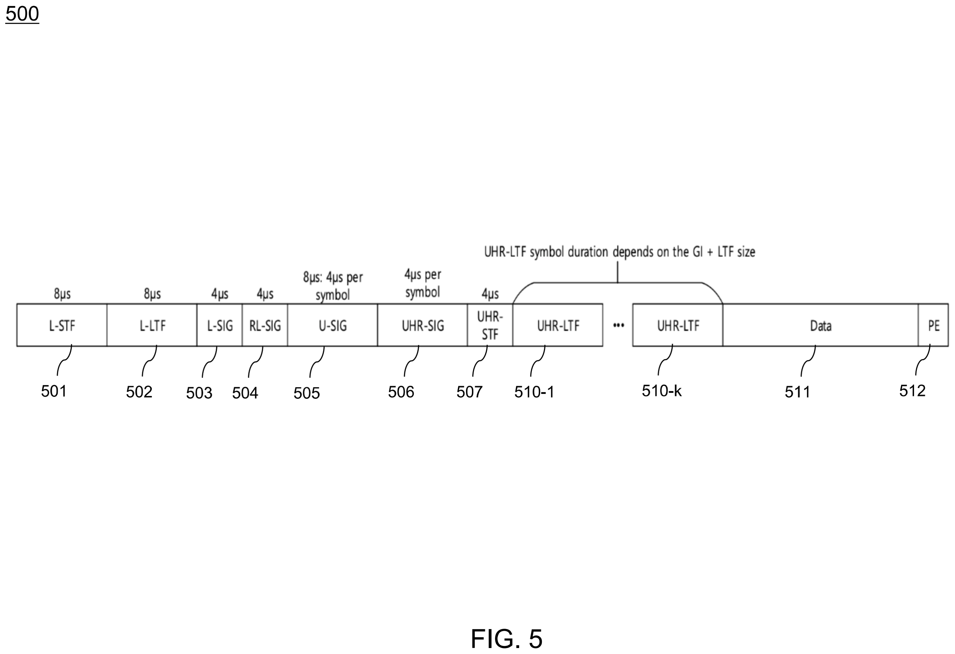

In some implementations, the system (e.g., transmitter communication system 105) can transmit or convey the signaling bit field $m_{2xLDPC}$ to a receiver to ensure accurate decoding of transmitted packets. For example, the system 105 can transmit a frame (e.g., PPDU) 190 which includes the signaling bit field $m_{2xLDPC}$ in a preamble 192 of the frame. FIG. 5 is a diagram depicting an example PPDU format 500 including a bit indicating a particular codeword length (e.g., 3888 bits). For example, the PPDU 500 can be a UHR multi-user (MU) PPDU which is used for transmission to one or more users and is not a response to a triggering frame. The PPDU format 500 may include fields of a preamble, data 511, and packet extension (PE) 512. The preamble may include L-STF (non-HT (high throughput) short training field) 501, L-LTF (non-HT long training field) 502, L-SIG (non-HT signal) 503, RL-SIG (repeated non-HT signal) 504, U-SIG (universal signal) 505, UHR-SIG (UHR signal) 506, UHR-STF (UHR non-HT long training field) 507, and/or UHR-LTF (UHR non-HT long training field) 510-1 to UHR-LTF 510-k. The PPDU 500 can include a signaling bit $m_{2xLDPC}$ as part of the UHR-SIG field 506. The UHR-SIG field 506 including the signaling bit $m_{2xLDPC}$ can be present in the UHR MU PPDU 500.

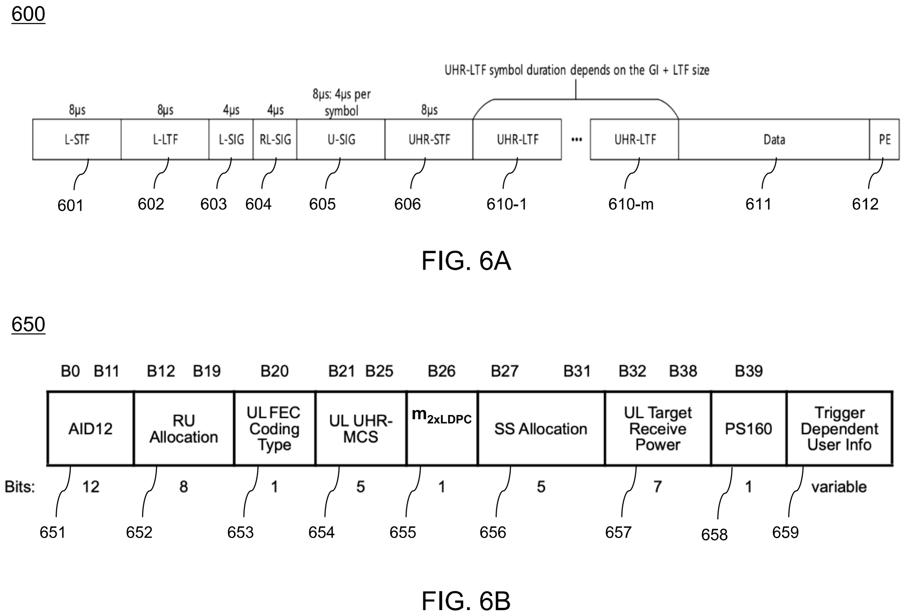

FIG. 6A and FIG. 6B are diagrams depicting example PPDU formats 600, 650 including a bit indicating a particular codeword length (e.g., 3888 bits), according to one or more embodiments. Referring to FIG. 6A, a UHR trigger-based (TB) PPDU 600 can be used for a transmission that is a response to a triggering frame from an AP. The PPDU format 600 may include fields of a preamble, data 611, and packet extension (PE) 612. The preamble may include L-STF 601, L-LTF 602, L-SIG 603, RL-SIG 604, U-SIG 605, UHR-STF 606, and/or UHR-LTF 610-1 to UHR-LTF 610-m. In the UHR TB PPDU 600, the UHR-SIG field may not be present and the duration of the UHR-STF field 606 (e.g., 8 $\mu$s) may be twice the duration of the UHR-STF field 507 (e.g., 4 $\mu$s) in the UHR MU PPDU 500.

Referring to FIG. 6B, a UHR variant User Info field can be defined for all Trigger frame variants except the Neighbor Discovery Protocol (NDP) Feedback Report Poll (NFRP) Trigger frame and the MU-RTS (Request to Send) TXS (Transmit Opportunity Sharing) Trigger frame. The User Info field in the UHR TB PPDU can have a signaling bit $m_{2xLDPC}$. As shown in FIG. 6B, a User Info field 650 in the UHR TB PPDU 600 may include subfields of AID12 651, RU Allocation 652, UL FEC Coding Type 653, UL UHR-MCS 654, $m_{2xLDPC}$ 655, SS Allocation 656, UL Target Receive Power 657, PS160 658, and/or Trigger Dependent User Info 659. As shown in FIG. 6B, the signaling bit $m_{2xLDPC}$ 655 may be bit 26 of the User Info field 650 in the UHR TB PPDU 600.

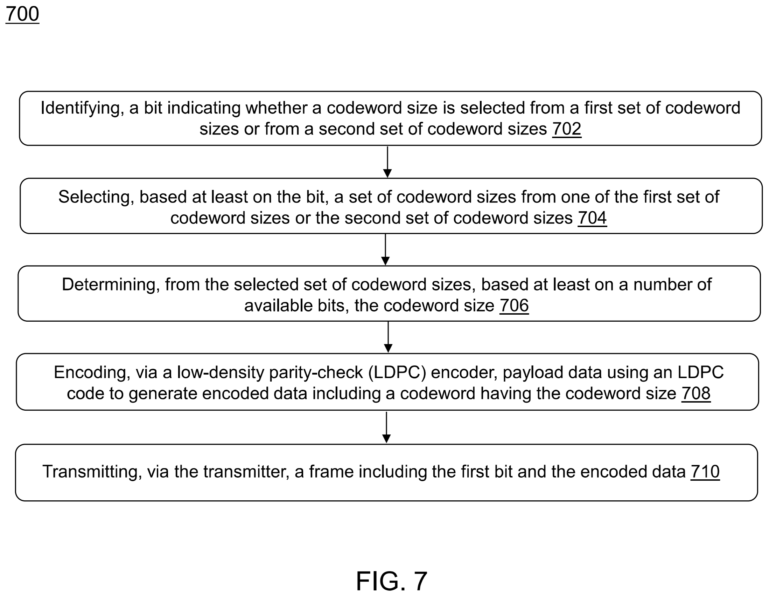

FIG. 7 is a flow diagram showing a process 700 for encoding data using a bit indicating a particular codeword length (e.g., 3888 bits), in accordance with one or more embodiments. In some implementations, the process 700 is performed by one or more processors of an apparatus (e.g., an encoder 130 or a processor 2010 of a communication system 105). In other embodiments, the process 700 is performed by other entities (e.g., a computing system other than the system 105). In some embodiments, the process 700 includes more, fewer, or different steps than shown in FIG. 7.

At step 702, the one or more processors (e.g., RM controller 310, bit selector 360, parameter selector 370) may identify a bit (e.g., $m_{2xLDPC}$ bit in the UHR-SIG 506, $m_{2xLDPC}$ bit 655) indicating whether a codeword size is selected from a first set of codeword sizes (e.g., set of (648, 1296, 1944) bits) or from a second set of codeword sizes (e.g., set of (648, 1296, 1944, 3888) bits).

In some implementations, the one or more processors may be configured to identify a percentage of punctured bits (e.g., puncturing shown in FIG. 4B) in an encoding process performed by the LDPC encoding (e.g., LDPC encoding by LDPC encoder 330). The one or more processors may be configured to determine that the percentage of punctured bits is greater than a threshold. The one or more processors may be configured to set the bit (e.g., $m_{2xLDPC}$ bit) to a first value (e.g., 0) to indicate that the codeword size is selected from the first set of codeword sizes.

In some implementations, the one or more processors may be configured to determine a value of the bit (e.g., $m_{2xLDPC}$ bit) using at least one of a length of the payload, a modulation and coding scheme (MCS), a modulation size, a bandwidth, a resource unit, a data rate, latency requirements of applications, a percentage of punctured bits, or a ratio of puncturing to shortening.

In some implementations, the first set of codeword size (e.g., set of (648, 1296, 1944) bits) may include a first value (e.g., 1944). The second set of codeword size (e.g., set of (648, 1296, 1944, 3888) bits) may include a second value (e.g., 3888) that is twice the first value. In some implementations, the first set may be a subset of the second set.

In some implementations, the first set of codeword sizes may include a codeword size of 1944 bits. The first set of codeword sizes may include a codeword size of 648, 1296 or 1944 bits. The second set of codeword sizes may include a codeword size of 3888 bits.

At step 704, the one or more processors may select, based at least on the bit, a set of codeword sizes from one of the first set of codeword sizes or the second set of codeword sizes. For example, the parameter selector may select, based on a value of the $m_{2xLDPC}$ bit, a set of (648, 1296, 1944, 3888) bits.

At step 706, the one or more processors may determine, from the selected set of codeword sizes (e.g., set of (648, 1296, 1944, 3888) bits), based at least on a number of available bits (e.g., the number of available bits $N_{avbits}$), the codeword size (e.g., codeword size (or length) $L_{LDPC}$). In some implementations, the one or more processors may be configured to calculate, based on a length of the payload data (e.g., the PPDU payload size (or length) $N_{pld}$), the number of available bits for error correction (e.g. using Equation 2). The payload data refers to (1) user data or message excluding any headers, metadata, or other protocol overhead, (2) actual intended message or information being transmitted over a network, or (3) core content of a data packet that the sender wants to deliver to the receiver. For example, the codeword size (e.g., 3888 bits) can be determined based on $N_{avbits}$ and the $m_{2xLDPC}$ bit using Table 1.

At step 708, the one or more processors may encode, via a low-density parity-check (LDPC) encoder (e.g., LDPC encoder 330), payload data using an LDPC code to generate encoded data including a codeword having the codeword size (e.g., codeword size (or length) $L_{LDPC}$).

At step 710, the one or more processors may transmit, via a transmitter (e.g., transmitter circuitry 120), a frame (e.g., frame 190) including the bit (e.g., a bit in the preamble 192) and the encoded data.

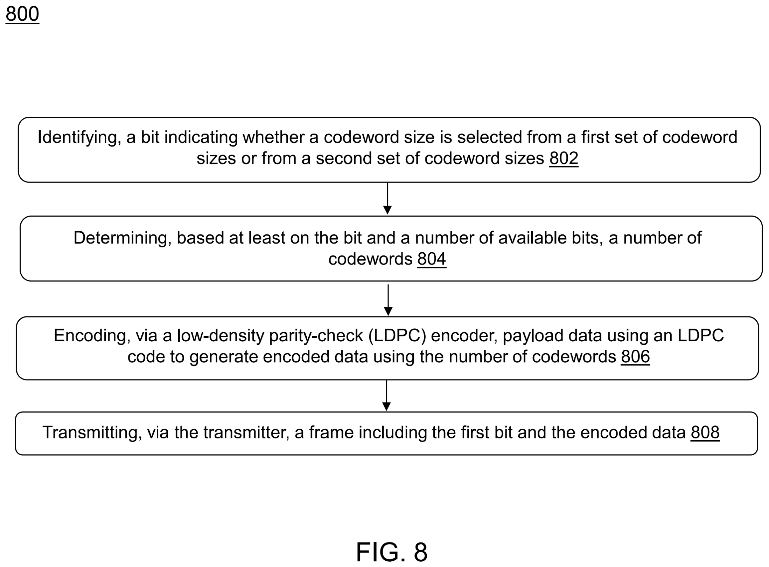

FIG. 8 is a flow diagram showing a process 800 for encoding data using a bit indicating a particular codeword length (e.g., 3888 bits), in accordance with one or more embodiments. In some implementations, the process 800 is performed by one or more processors of an apparatus (e.g., an encoder 130 or a processor 2010 of a communication system 105). In other embodiments, the process 800 is performed by other entities (e.g., a computing system other than the system 105). In some embodiments, the process 800 includes more, fewer, or different steps than shown in FIG. 8.

At step 802, the one or more processors (e.g., RM controller 310, bit selector 360, parameter selector 370) may identify a bit (e.g., $m_{2xLDPC}$ bit in the UHR-SIG 506, $m_{2xLDPC}$ bit 655) indicating whether a codeword size is selected from a first set of codeword sizes (e.g., set of (648, 1296, 1944) bits) or from a second set of codeword sizes (e.g., set of (648, 1296, 1944, 3888) bits).

In some implementations, the one or more processors may be configured to identify a percentage of punctured bits (e.g., puncturing shown in FIG. 4B) in an encoding process performed by the LDPC encoding (e.g., LDPC encoding by LDPC encoder 330). The one or more processors may be configured to determine that the percentage of punctured bits is greater than a threshold. The one or more processors may be configured to set the bit (e.g., $m_{2xLDPC}$ bit) to a first value (e.g., 0) to indicate that the codeword size is selected from a first set of codeword sizes.

In some implementations, the first set of codeword size (e.g., set of (648, 1296, 1944) bits) may include a first value (e.g., 1944). The second set of codeword size (e.g., set of (648, 1296, 1944, 3888) bits) may include a second value (e.g., 3888) that is twice the first value. In some implementations, the first set may be a subset of the second set.

In some implementations, the first set of codeword sizes may include a codeword size of 1944 bits. The first set of codeword sizes may include a codeword size of 648, 1296 or 1944 bits. The second set of codeword sizes may include a codeword size of 3888 bits.

At step 804, the one or more processors may determine, based at least on the bit (e.g., the $m_{2xLDPC}$ bit) and a number of available bits (e.g., the number of available bits $N_{avbits}$), a number of codewords (e.g., the number of codewords $N_{CW}$). In some implementations, the number of codewords may be determined using the bit, the number of available bits, and a code rate of the LDPC code. For example, the number of codewords $N_{CW}$ can be determined based on $N_{avbits}$, $N_{pld}$, code rate $R$, and the $m_{2xLDPC}$ bit using Table 1.

At step 806, the one or more processors may encode, via a low-density parity-check (LDPC) encoder (e.g., LDPC encoder 330), payload data using an LDPC code to generate encoded data using the number of codewords (e.g., the number of codewords $N_{CW}$).

At step 808, the one or more processors may transmit, via the transmitter (e.g., transmitter circuitry 120), a frame (e.g., frame 190) including the bit (e.g., a bit in the preamble 192) and the encoded data.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

**Claims**

1. A method, comprising:

   identifying, by one or more processors, a bit indicating whether a codeword size is selected from a first set of codeword sizes or from a second set of codeword sizes;
   selecting, by the one or more processors, based at least on the bit, a set of codeword sizes from one of the first set of codeword sizes or the second set of codeword sizes;

determining, by the one or more processors, from the selected set of codeword sizes, based at least on a number of available bits, the codeword size;

encoding, by the one or more processors, via a low-density parity-check, LDPC, encoder, payload data using an LDPC code to generate encoded data including a codeword having the codeword size; and

transmitting, by the one or more processors via the transmitter, a frame including the bit and the encoded data.

2. The method of claim 1, wherein

the first set of codeword size includes a first value, and
the second set of codeword size includes a second value that is twice the first value.

3. The method of claim 2, wherein
the first set is a subset of the second set.

4. The method of claim 2 or3, further comprising:

identifying a percentage of punctured bits in an encoding process performed by the LDPC encoding;
determining that the percentage of punctured bits is greater than a threshold; and
setting the bit to a first value to indicate that the codeword size is selected from the first set of codeword sizes.

5. The method of any one of the claims 1 to 4, wherein

the first set of codeword sizes includes a codeword size of 648, 1296 or 1944 bits, and
the second set of codeword sizes includes a codeword size of 3888 bits.

6. The method of any one of the claims 1 to 5, further comprising:
determining a value of the bit using at least one of a length of the payload, a modulation and coding scheme, MCS, a modulation size, a bandwidth, a resource unit, a data rate, latency requirements of applications, a percentage of punctured bits, or a ratio of puncturing to shortening.

7. The method of any one of the claims 1 to 6, further comprising:
calculating, based on a length of the payload data, the number of available bits for error correction.

8. A system, comprising:

a transmitter; and
one or more processors configured to control and/or carry out a method as set forth in any one of the preceding claims.

9. A system, comprising:

a transmitter; and
one or more processors configured to:

identify a bit indicating whether a codeword size is selected from a first set of codeword sizes or from a second set of codeword sizes;
determine, based at least on the bit and a number of available bits, a number of codewords;
encode, via a low-density parity-check, LDPC, encoder, payload data using an LDPC code to generate encoded data using the number of codewords; and
transmit, via the transmitter, a frame including the bit and the encoded data.

10. The system of claim 9, wherein

the first set of codeword size includes a first value, and
the second set of codeword size includes a second value that is twice the first value.

11. The system of claim 10, wherein
the first set is a subset of the second set.

12. The system of claim 10 or 11, wherein the one or more processors are configured to:

   identify a percentage of punctured bits in an encoding process performed by the LDPC encoding;
   determine that the percentage of punctured bits is greater than a threshold; and
   set the bit to a first value to indicate that the codeword size is selected from a first set of codeword sizes.

13. The system of any one of the claims 9 to 12, wherein

   the first set of codeword sizes includes a codeword size of 648, 1296 or 1944 bits, and
   the second set of codeword sizes includes a codeword size of 3888 bits.

14. The system of any one of the claims 9 to 13, wherein
   the number of codewords is determined using the bit, the number of available bits, and a code rate of the LDPC code.

FIG. 1

FIG. 2

FIG. 3

EP 4 730 661 A1

EP 4 730 661 A1

400

| Data bits | → | Data bits | 0..0 |

401

402

encode →

| Data bits | 0..0 | Parity bits |

401

discard →

| Data bits | Parity bits |

## FIG. 4A

440

| Data bits | Parity bits |

→ discard

| Data bits | Parity bits | |

441

## FIG. 4B

480

| | Data bits | |

→ copy

| | Data bits | | |

481

## FIG. 4C

EP 4 730 661 A1

500

FIG. 5

EP 4 730 661 A1

<u>600</u>

UHR-LTF symbol duration depends on the GI + LTF size

| 8µs | 8µs | 4µs | 4µs | 8µs: 4µs per symbol | 8µs | | | | | |
|---|---|---|---|---|---|---|---|---|---|---|
| L-STF | L-LTF | L-SIG | RL-SIG | U-SIG | UHR-STF | UHR-LTF | ••• | UHR-LTF | Data | PE |

601 602 603 604 605 606 610-1 610-m 611 612

**FIG. 6A**

<u>650</u>

| B0  B11 | B12  B19 | B20 | B21 B25 | B26 | B27  B31 | B32  B38 | B39 | |
|---|---|---|---|---|---|---|---|---|
| AID12 | RU Allocation | UL FEC Coding Type | UL UHR-MCS | $m_{2xLDPC}$ | SS Allocation | UL Target Receive Power | PS160 | Trigger Dependent User Info |

Bits: 12 8 1 5 1 5 7 1 variable

651 652 653 654 655 656 657 658 659

**FIG. 6B**

700

Identifying, a bit indicating whether a codeword size is selected from a first set of codeword sizes or from a second set of codeword sizes 702

Selecting, based at least on the bit, a set of codeword sizes from one of the first set of codeword sizes or the second set of codeword sizes 704

Determining, from the selected set of codeword sizes, based at least on a number of available bits, the codeword size 706

Encoding, via a low-density parity-check (LDPC) encoder, payload data using an LDPC code to generate encoded data including a codeword having the codeword size 708

Transmitting, via the transmitter, a frame including the first bit and the encoded data 710

FIG. 7

```
┌─────────────────────────────────────────────────────────────────────┐
│ Identifying, a bit indicating whether a codeword size is selected     │
│ from a first set of codeword sizes or from a second set of            │
│ codeword sizes 802                                                     │
└─────────────────────────────────────────────────────────────────────┘
                                   │
                                   ▼
┌─────────────────────────────────────────────────────────────────────┐
│ Determining, based at least on the bit and a number of available      │
│ bits, a number of codewords 804                                       │
└─────────────────────────────────────────────────────────────────────┘
                                   │
                                   ▼
┌─────────────────────────────────────────────────────────────────────┐
│ Encoding, via a low-density parity-check (LDPC) encoder, payload      │
│ data using an LDPC code to generate encoded data using the number     │
│ of codewords 806                                                      │
└─────────────────────────────────────────────────────────────────────┘
                                   │
                                   ▼
┌─────────────────────────────────────────────────────────────────────┐
│ Transmitting, via the transmitter, a frame including the first bit     │
│ and the encoded data 808                                              │
└─────────────────────────────────────────────────────────────────────┘
```

FIG. 8

**EUROPEAN SEARCH REPORT**

Application Number

EP 25 20 8929

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/089030 A1 (LI QINGHUA [US] ET AL) 14 March 2024 (2024-03-14) * the whole document * ----- | 1-14 | INV. H03M13/11 H03M13/00 H04L1/00 |
| A | US 2024/048271 A1 (FANG JUAN [US] ET AL) 8 February 2024 (2024-02-08) * the whole document * ----- | 7,14 | |

TECHNICAL FIELDS SEARCHED (IPC)

H03M
H04L

The present search report has been drawn up for all claims

| Place of search | Date of completion of the search | Examiner |
|---|---|---|
| Munich | 18 February 2026 | Wu, Zifeng |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 8929

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2026

| Patent document cited in search report | Publication date | Patent family member(s) | | Publication date |
|---|---|---|---|---|
| US 2024089030 A1 | 14-03-2024 | CN | 119865280 A | 22-04-2025 |
| | | US | 2024089030 A1 | 14-03-2024 |
| US 2024048271 A1 | 08-02-2024 | EP | 4542864 A1 | 23-04-2025 |
| | | US | 2024048271 A1 | 08-02-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RICHARDSON** ; **URBANKE**. *IEEE Transactions on Information Theory*, February 2001, vol. 47 (2)